# EUROPÄISCHE PATENTSCHRIFT

(11) **EP 0 825 810 B1**
(45) Veröffentlichungstag und Bekanntmachung des Hinweises auf die Patenterteilung: **03.11.1999**
(21) Anmeldenummer: 97810529.4
(22) Anmeldetag: 24.07.1997
(51) Int. Cl.: H05K 5/02

(54) **Gehäuse mit einer Belüftungsvorrichtung für ein elektronisches Gerät**
Housing for an electronic apparatus with a venting arrangement
Boîtier pour appareil électronique comprenant un dispositif d'aération

(30) Priorität: 23.08.1996 DE 19634002
(43) Veröffentlichungstag der Anmeldung: 25.02.1998
(73) Patentinhaber: Asea Brown Boveri AG, 5401 Baden (CH)
(72) Erfinder: Füglister, Marcel, 5272 Gansingen (CH)
(74) Vertreter: Kaiser, Helmut

(56) Entgegenhaltungen:
- EP-A- 0 377 067
- DE-C- 4 313 776
- GB-A- 2 260 971

## Beschreibung

### TECHNISCHES GEBIET

Bei der Erfindung wird ausgegangen von einem elektronischen Gerät nach dem Oberbegriff von Patentanspruch 1. Insbesondere in der Energietechnik sind elektronische Geräte häufig atmosphärischen Bedingungen ausgesetzt. Hierbei kann kondensierender Wasserdampf die Funktionsfähigkeit der im Gerät vorhandenen elektronischen Komponenten ganz wesentlich beeinträchtigen.

### STAND DER TECHNIK

Ein elektronisches Gerät der eingangs genannten Art ist in DE 42 10 979 C2 beschrieben. Dieses Gerät enthält eine in einem zweiteiligen, wasserdichten Gehäuse 1 befestigte und mit elektrischen und/oder optischen Elementen bestückbare Leiterplatte 3. Das Gehäuseinnere kommuniziert über einen Kanal 20 und ein den Kanal abschliessendes Belüftungselement 23 aus einer textilen Membran aus gasdurchlässigem und flüssigkeitsdichtem PTFE mit der Aussenluft. Hierdurch wird der Zutritt von Wasser ins Gehäuseinnere verhindert und ist zugleich ein ausreichender Gasaustausch gewährleistet. Eine durchsichtige Abdeckung 25 schirmt einen elektrischen Verbinder 2 der Leiterplatte und die Membran gegen Umwelteinflüsse ab.

Aus DE 43 13 776 C1 ist eine stutzenförmig ausgebildete Belüftungsvorrichtung für ein Gerätegehäuse bekannt. Diese Belüftungsvorrichtung weist einen zweiteilig ausgebildeten Spritzwasserschutz mit einem Rohrstutzen 3 und einem Becher 4 auf. In den Rohrstutzen und den Becher ist ein das Gehäuseinnere mit der Aussenluft verbindendes Labyrinth eingeformt, welches das Austreten von Wasser aus dem Gehäuseinnere ermöglicht und das Eindringen von Spritzwasser verhindert. Staub wird durch ein im Rohrstutzen 3 angeordnetes Staubfilter vom Gehäuseinneren ferngehalten.

### KURZE DARSTELLUNG DER ERFINDUNG

Der Erfindung, wie sie in Patentanspruch 1 definiert ist, liegt die Aufgabe zugrunde, ein elektronisches Gerät der eingangs genannten Art zu schaffen, welches in einfacher und kostengünstiger Weise hergestellt werden kann, und welches sich auch unter extremen klimatischen Bedingungen durch grosse Betriebssicherheit auszeichnet.

Das Gerät nach der Erfindung zeichnet sich dadurch aus, dass es obwohl es unter extremen klimatischen Bedingungen eingesetzt werden kann, lediglich ein wasserdicht abgeschlossenes und daher leicht zu fertigendes luftdurchlässiges Gehäuse aufweist. Da das Innere des Gehäuses dem atmosphärischen Luftdruck ausgesetzt ist, kann die Elektronik des Gerätes durch Öffnen des Gehäuses unter atmosphärischen Bedingungen jederzeit überprüft und revidiert werden.

Da neben einer in einer Belüftungsöffnung der Gehäusewand angeordneten wasserabweisenden und gasdurchlassenden Membran auch ein Spitzwasserschutz vorgesehen ist, werden Kondenswasserbildung im Gehäuseinneren und das Eindringen von Spritzwasser ins Gehäuseinnere und damit eine Beeinträchtigung der Funktionsfähigkeit der Elektronik mit grosser Sicherheit verhindert.

Der der Membran vorgeschaltete und als Bolzen ausgebildete Spritzwasserschutz setzt die Membran in gasdichter Weise im Inneren des Bolzens fest und ermöglicht so einen besonders einfachen und kompakten Aufbau der Belüftungsvorrichtung. Zugleich stellt der Spritzwasserschutz sicher, dass eingedrunges Spritzwasser auch bei veränderter Lage des elektronischen Gerätes wieder austreten kann. Eine Ablagerung von Wasser auf der Membran kann so mit grosser Sicherheit vermieden werden. Durch abgelagertes - gegebenenfalls gefrierendes - Wasser, könnte sonst die Membran verstopft werden. Im Gehäuseinneren gebildeter Wasserdampf könnte dann nicht mehr durch die Membran nach aussen geführt werden.

### KURZE BESCHREIBUNG DER ZEICHNUNGEN

Bevorzugte Ausführungsbeispiele der Erfindung und die damit erzielbaren weiteren Vorteile werden nachfolgend anhand von Zeichnungen näher erläutert. Hierbei zeigt:
- Fig.1: in axialer Richtung geschnitten ein Teil einer gasisolierten, metallgekapseltenen Hochspannungsanlage mit einem in die Metallkapselung eingebauten und ein zweiteiliges Metallgehäuse aufweisenden elektronischen Gerät nach der Erfindung,
- Fig.2: eine Seitenansicht eines als Federleiste ausgebildeten Teils einer im Metallgehäuse angeordneten Steckvorrichtung zur Verbindung der Ausgänge von Sensoren der Hochspannungsanlage mit einer im elektronischen Gerät gemäss Fig.1 vorgesehenen Auswertevorrichtung,
- Fig.3: eine Seitenansicht von rechts auf einen das Metallgehäuse enthaltenden Teil der Hochspannungsanlage
- Fig.4: eine Untersicht eines als trogförmiges Gehäuseelement ausgeführten Teils des Metallgehäuses,
- Fig.5: eine Seitenansicht einer in einer Belüftungsöffnung des Gehäuseelementes gemäss Fig.4 angeordneten Belüftungsvorrichtung,
- Fig.6: eine Draufsicht auf einen Spritzwasserschutz der Belüftungsvorrichtung gemäss Fig.5,
- Fig.7: eine Explosionsdarstellung des Spritzwasserschutzes gemäss Fig.6, und
- Fig.8: eine Aufsicht auf einen Schnitt durch eine weitere Ausführungsform einer Belüftungsvorrichtung, deren Spitzwasserschutz gegenüber dem Spritzwasserschutz der Belüftungsvorrichtung gemäss Fig.5 abgeändert ist.

### WEGE ZUR AUSFÜHRUNG DER ERFINDUNG

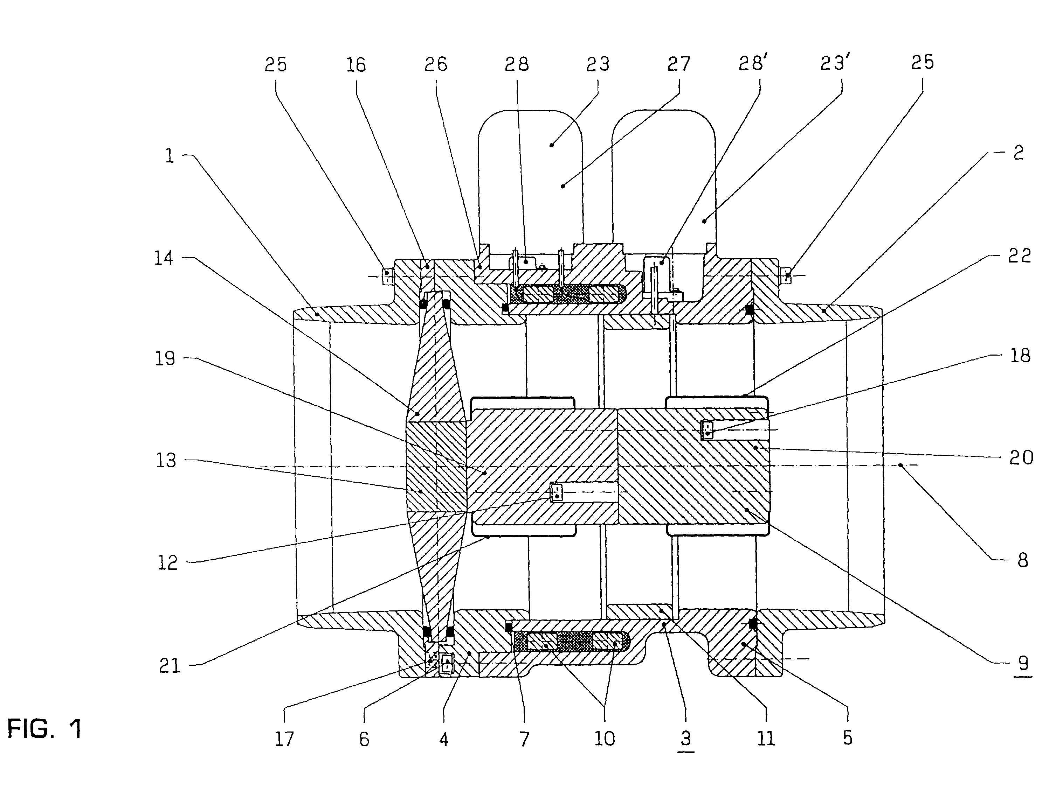

In allen Figuren bezeichnen gleiche Bezugszeichen auch gleichwirkende Teile. Die in Fig.1 dargestellte Messvorrichtung weist ein zwischen zwei Flanschen 1, 2 einer mit einem Isoliergas, wie insbesondere SF₆, von bis zu einigen bar Druck gefüllten Metallkapselung eingespanntes Kapselungsrohr 3 auf. Das Kapselungsrohr 3 ist von zwei jeweils einen Flansch aufweisenden metallenen Rohrabschnitten 4, 5, gebildet, welche mittels Schrauben 6 und einem Dichtungsring 7 in gasdichter Weise miteinander verspannt sind. Auf der Achse 8 des Kapselungsrohrs 3 ist ein im wesentlichen zylinderförmig ausgebildeter und auf einem Hochspannungspotential von typischerweise mehreren hundert kV befindlicher Stromleiter 9 geführt. In einem von den beiden Rohrabschnitten 4, 5 begrenzten Hohlraum befinden sich zwei Rogowskispulen 10, welche den im Stromleiter 9 geführten Strom detektieren. Auf der dem Stromleiter 9 zugewandten Innenfläche des Kapselungsrohrs ist in einer von den Rohrabschnitten 4 und 5 begrenzten Ringnut eine gegenüber dem Kapselungsrohr 3 elektrisch isoliert angeordnete, die am Stromleiter 9 anliegende Hochspannung erfassende metallene Messelektrode 11 angebracht.

Der Stromleiter 9 ist mit Hilfe von Schrauben 12 starr verbunden mit einer auf der Achse 8 angeordneten Eingussarmatur 13 eines Isolators 14. Die Schrauben 12 sind in Richtung der Achse 8 geführt und sind mit einer Versiegelung (Siegellack) oder einer Plombierung gegen unbefugtes Betätigen geschützt. Der ringförmige Aussenrand des Isolators 14 ist mit Hilfe eines axial geführten Halteringes 16 am Flansch des Rohrabschnitts 4 fixiert. Den Haltering 16 am Rohrabschnitt 4 fixierende Schrauben 17 sind mit Hilfe einer Versiegelung oder einer Plombierung ebenfalls gegen unbefugtes Betätigen geschützt.

Der Stromleiter 9 wird ersichtlich von zwei durch axial geführte Schrauben 18 starr miteinander verbundenen Leiterabschnitte 19, 20 gebildet. Hierdurch wird erreicht, dass die den Stromleiter 9 am Isolator 14 fixierenden Schrauben 12 relativ kurz sein können. Die Schrauben 18 sind wie die Schrauben 12 und 17 durch eine Versiegelung oder durch eine Plombierung gegen unbefugtes Betätigen geschützt. Entsprechendes gilt auch für nicht bezeichneten weiteren Schrauben, die der starren Befestigung von Abschirmungen 21, 22 am Stromleiter 9 dienen.

Durch die starre Befestigung des Stromleiters 9 am fest mit dem Kapselungsrohr 3 verbundenen Isolator 14 anstelle der sonst üblichen schwimmenden Lagerung des Stromleiters 9 auf Federkontakten sowie die definierte Halterung der Abschirmungen kann eine definierte Feldgeometrie im Inneren des Kapselungsrohrs 9 eingehalten werden. Dies ist von entscheidender Bedeutung für des Genauigkeit eines von der Messelektrode 11 abgegebenen spannungsproportionalen Signals. Durch die Sicherung der Schrauben 12, 17, 18 sowie der Abschirmungen 21, 22 wird erreicht, dass nach der Fertigstellung des hochspannungsbelasteten Teils der Messvorrichtung deren Feldgeometrie nicht verändert wird. Die in der Messvorrichtung enthaltenen Sensoren, wie die Rogowskispulen 10, die Messelektrode 11 sowie weitere gegebenenfalls vorhandene Sensoren, wie etwa Temperatur-, Druck-und Dichtefühler, Teilentladungssensoren und Lichtbogenwächter, können nun geeicht werden und die hierbei ermittelten Eichwerte sowie weitere Kenngrössen, wie Kompensationskurven, die beispielsweise temperaturbedingte Messabweichungen erfassen, in einem nicht überschreibbaren Datenspeicher (beispielsweise einem PROM) einer ausserhalb des isoliergasgefüllten Innenraums des Kapselungsrohrs 3 angeordneten elektronischen Auswertevorrichtung 23 der Messvorrichtung gespeichert werden. Dieser Datenspeicher kann durch Plombierung oder Versiegelung ebenfalls gegen unbefugtes Betätigen geschützt werden und ist lediglich der Elektronik der Auswertevorrichtung 23 zugänglich. Weist die Elektronik der Auswertevorrichtung 23 Mängel auf, so kann nach deren Austausch die neu in die Auswertevorrichtung eingesetzte Elektronik direkt auf die im PROM abgelegten Daten zugreifen. Kalibrierarbeiten beim Auswechseln der Elektronik können daher entfallen.

Die Messvorrichtung gemäss Fig.1 kann durch Verspannen des Flansches 1 und des Rohrabschnitts 4 sowie des Flansches 2 und des Rohrabschnitts 5 mit Hilfe von Spannschrauben 25 gasdicht (aus den Figuren ersichtliche nicht bezeichnete Dichtungsringe) in die Metallkapselung eingebaut werden.

Die Ausgänge der Rogowskispulen 10 und der Messelektrode 11 sind über abgeschirmte Messkabel und Gehäusedurchführungen, von denen die Gehäusedurchführung für das mit der Messelektrode 11 verbundene Messkabel gasdicht ausgeführt ist, an die in einem zweiteiligen Metallgehäuse untergebrachte Auswertevorrichtung 23 geführt. Eine weitere Auswertevorrichtung 23' kann in einem weiteren Metallgehäuse vorgesehen sein. Die Auswertevorrichtung 23 kann überwiegend zur Verarbeitung der Ausgangssignale der Rogowskispulen 10, die Auswertevorrichtung 23' überwiegend zur Verarbeitung der Ausgangssignale der Messelektrode 11 bestimmt sein. Die Ausgangssignale der Rogowskispulen 10 können aber auch in die Auswertevorrichtung 23' und umgekehrt die Ausgangssignale der Messelektrode 11 in die Auswertevorrichtung 23 geführt werden. Die Auswertevorrichtung 23 kann auch die Aufgaben der Auswertevorrichtung 23' und die Auswertevorrichtung 23' die Aufgaben der Auswertevorrichtung 23 übernehmen. Beide Auswertevorrichtung 23 und 23' können auch synchron zusammenwirken. Eine solche Messvorrichtung weist eine besonders grosse Redundanz auf, da beim Ausfall einer der beiden Auswertevorrichtungen die noch betriebsbereite Auswertevorrichtung die weitere Verarbeitung der Sensorausgangssignale durchführen kann.

Das eine Teil des Metallgehäuses ist jeweils von einem an die Aussenfläche des Kapselungsrohrs 3 angeformten metallenen Hohlflansch 26 und dem vom Hohlflansch umrandeten Bereich des Kapselungsrohrs 3 gebildet. Das andere Teil ist ein trogförmig vertieftes Gehäuseelement 27, welches mit seinem die Trogöffnung begrenzenden Rand am metallenen Hohlflansch 26 des Kapselungsrohrs 3 befestigt ist. In diesem Metallgehäuse ist die Auswertevorrichtung 23 vor elektromagnetischen und mechanischen Einwirkungen geschützt untergebracht. Da so lange Übertragungswege zwischen den Sensoren und der Auswertevorrichtung 23 und daraus resultierende Störungen entfallen, können die Verarbeitungsgeschwindigkeit und die Messgenauigkeit beträchtlich gesteigert werden.

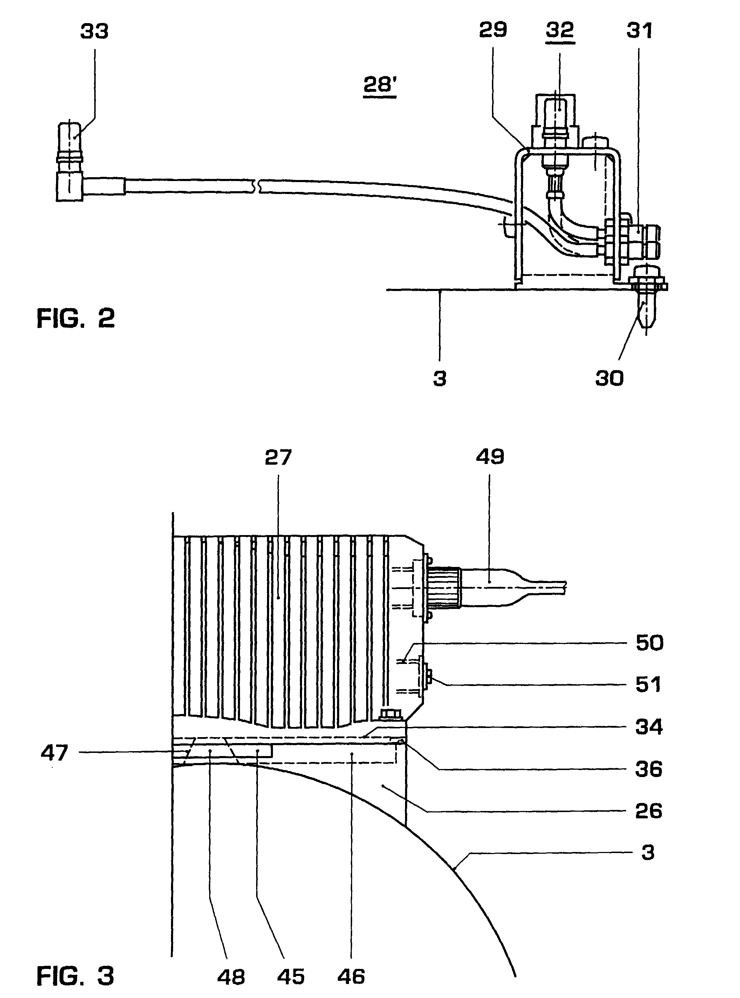

Die die Ausgangssignale der Sensoren in das Metallgehäuse führenden abgeschirmten Messkabel sind an eine in Inneren des Metallgehäuses angeordnete Steckvorrichtung 28 bzw. 28' geführt. Die Steckvorrichtung 28 bzw. 28' weist ein in einer quer zur Steckrichtung erstreckten ebenen Auflagefläche des umrandeten Bereichs des Kapselungsrohrs 3 schwimmend gelagertes Steckteil auf. Dieses Steckteil ist in Fig.2 für die Steckvorrichtung 28' dargestellt. Es weist eine gewinkelt ausgebildete und ein Z-winkelförmiges Profil enthaltende Federleiste 29 auf. Ein in der ebenen Auflagefläche geführter unterer Schenkel des Z-Winkels ist mittels am Kapselungsrohr gehaltener Schrauben 30 schwimmend gelagert. Ein L-förmig angesetzter mittlerer Schenkel des Z trägt ein mit einem Steckkontakt des Messkabels elektrisch leitend verbindbares Kupplungsstück 31. Der an den mittleren Schenkel angesetzte obere Schenkel des Z trägt ein mit dem Kupplungsstück 31 verbundenes Kupplungsstück 32, welches mit einem aus Fig.3 ersichtlichen Stecker 45 der Auswertevorrichtung 23 zusammenwirkt. Ein Steckkontakt des Kupplungstücks 31 kann über ein langes Leiterstück mit einem Steckkontakt 33 verbunden sein, welcher im benachbarten Metallgehäuse mit einem auf der Federleiste der Steckvorrichtung 28 angeordneten Kupplungsstück zusammenwirkt.

Alternativ kann der mittlere Schenkel des Z relativ kurz ausgebildet sein. Das Kupplungstück 31 kann dann an der Unterseite des oberen Schenkels des Z angebracht und direkt mit dem Kupplungstück 32 verbunden sein.

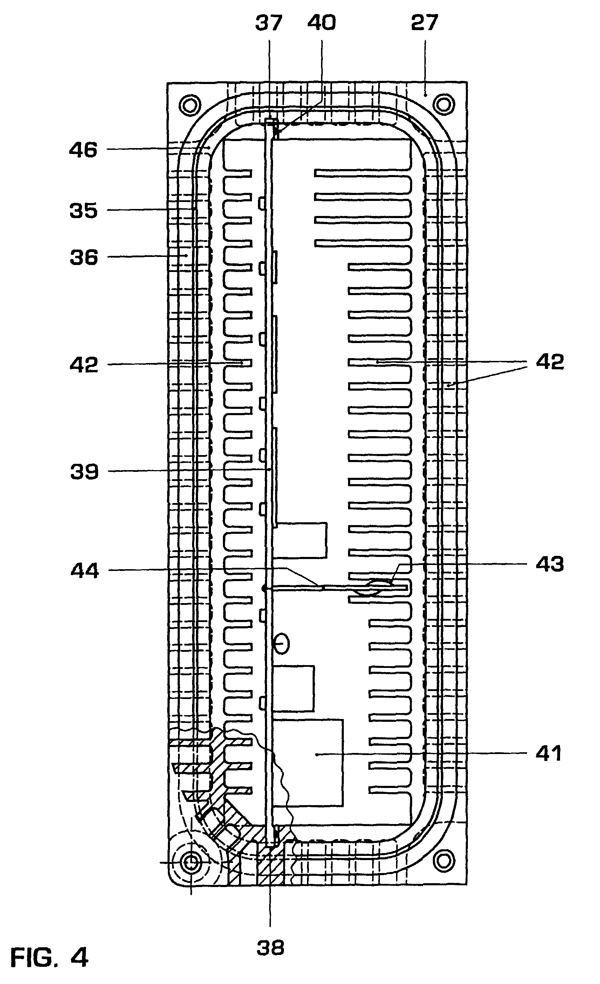

Aus den Figuren 3 und 4 sind der Aufbau und die Anordnung des die Auswertevorrichtung 23 bzw. 23' enthaltenden Metallgehäuses ersichtlich. Der Hohlflansch 26 weist eine um die Flanschöffnung geführte ebene Kontaktfläche 34 (Fig.3) auf, welche mit einer um die Trogöffnung geführten ebenen Kontaktfläche 35 des Trogrands (Fig.4) unter Bildung einer galvanischen Verbindung zusammenwirkt. Die beiden im wesentlichen vom Hohlflansch 26 und dem Gehäuseelement 27 gebildeten Teile des Metallgehäuses sind so miteinander elektrisch leitend verbunden und bilden einen Faradaykäfig für die Auswertevorrichtung. Die beiden ringförmig geschlossenen Kontaktflächen sind von mindestens einem zwischen dem Hohlflansch 26 und dem Trogrand eingespannten O-Ring 36 umgeben. Hierdurch wird eine praktisch gasdichte Verbindung der beiden Gehäuseteile erreicht und werden zugleich die beiden Kontaktflächen 34 und 35 vor von aussen zutretenden Schadstoffen geschützt.

Auf einander gegenüberstehenden Innenflächen des Gehäuseelementes 27 ist jeweils mindestens eine sich vom Trogrand in Richtung des Trogbodens erstreckende Nut 37 bzw. 38 eingeformt (Fig.4). Diese Nut dient der Aufnahme einer Kante einer mit einem oder mehreren Steckkontakten der Steckvorrichtung 28 bzw. 28' elektrisch leitend verbindbaren Printplatte 39 der Auswertevorrichtung. Die Nut 37 bzw. 38 ist mit Übermass ausgeführt und nimmt zusätzlich am Rand der Printplatte 39 angebrachte Kontakffedern 40 auf. Mit den Kontakffedern verbundene Leiterbahnen der Printplatte 39 werden so auf das Potential des Metallgehäuses geführt. Auf der Printplatte 39 befindliche elektronische Komponenten mit einer mit den Kontakffedern 40 galvanisch verbundenen Umhüllung 41 werden so elektromagnetisch abgeschirmt.

In das trogförmige Gehäuseelement 27 sind innen und/oder aussen Kühlrippen 42 eingeformt. Die inneren Kühlrippen nehmen von den elektronischen Komponenten gebildete Wärme auf. Diese Wärme wird nach aussen geleitet und von den äusseren Kühlrippen an die Umgebung abgegeben. Die inneren Kühlrippen können zusätzliche Aufgaben erfüllen. Wie aus Fig.4 ersichtlich ist, können zwischen zwei benachbart angeordneten Kühlrippen 42 ein Rand und Kontakffedern 43 einer plattenförmig ausgebildeten und zwischen zwei elektronischen Komponenten angeordneten elektromagnetischen Abschirmung 44 der Auswertevorrichtung angeordnet sein. Diese Abschimung 44 wirkt als elektromagnetische Barriere zwischen den benachbarten elektronischen Komponenten.

Die Trogöffnung ist abgeschlossen mit einer elektromagnetisch schirmenden Deckplatte sowie mit dem durch eine Öffnung der Deckplatte geführten Stecker 45, welcher mit dem Kupplungsstück 32 zusammenwirkende Steckkontakte trägt. Das Gehäuseelement 27 weist einen den Trogrand überragenden und durch die Flanschöffnung des Hohlflansch 26 geführten Kragen 46 auf. Der Kragen 46 steht zudem über den Stecker 45 vor und weist eine mit einer Auskragung 47 des Hohlflansches 26 zusammenwirkende Materialaussparung 48 auf (Fig.3).

Der Kragen 46 erfüllt folgende Funktionen: Bei der Montage der Messvorrichtung führt er das Gehäuseelement 27 in den Hohlflansch 26. Hierbei stellt die als Kodierung mit der Materialaussparung 48 zusammenwirkende Auskragung 47 sicher, dass das Gehäuseelement 27 und damit der Stecker 45 in der richtigen Lage in das Kupplungsstück 32 eingeführt wird. Es wird so ausgeschlossen, dass das Ausgangssignal etwa einer der Rogowskispulen 11 durch eine falsche Steckverbindung an eine zu dessen Verarbeitung ungeeignete Elektronikkomponente der Auswertevorrichtung geführt wird. Da der Kragen 46 über den Stecker 45 vorsteht, kann beim Zusammenbau der Stecker 45 nicht mit einem Teil des Hohlflansches in Berührung kommen und hierbei beschädigt werden.

Beim Zusammenbau ist es von Vorteil, dass die Federleiste 29 schwimmend gelagert ist. Nicht zu vermeidende Lageabweichungen des Kupplungsstücks 32 und des Steckers 45 können so in besondes einfacher Weise kompensiert werden.

Wie aus Fig.3 ersichtlich ist, ist am Gehäuseelement 27 ein Stecker 49 angebracht, welcher mit einem durch die Wand des Gehäuseelements 27 geführten und mit der Auswertevorrichtung 23 bzw. 23' verbundenen Kupplungsstück zusammenwirkt. Durch die so gebildete Steckverbindung kommuniziert die Auswertevorrichtung 23 bzw. 23' vorzugsweise über störfreie Lichtwellenleiter mit einer übergeordneten Leittechnik und wird die Auswertevorrichtung 23 bzw. 23' über eine Drahtverbindung gleichzeitig mit elektrischer Energie versorgt. Die Kommunikation umfasst vor allem die Übermittlung digitalisierter Messwerte, etwa des Stromes, der Spannung, der Temperatur, des Drucks oder der Dichte, an die Leittechnik, kann aber auch der Übermittlung von in der Leittechnik gebildeter Information an die Auswerteeinheit 23 bzw. 23' dienen.

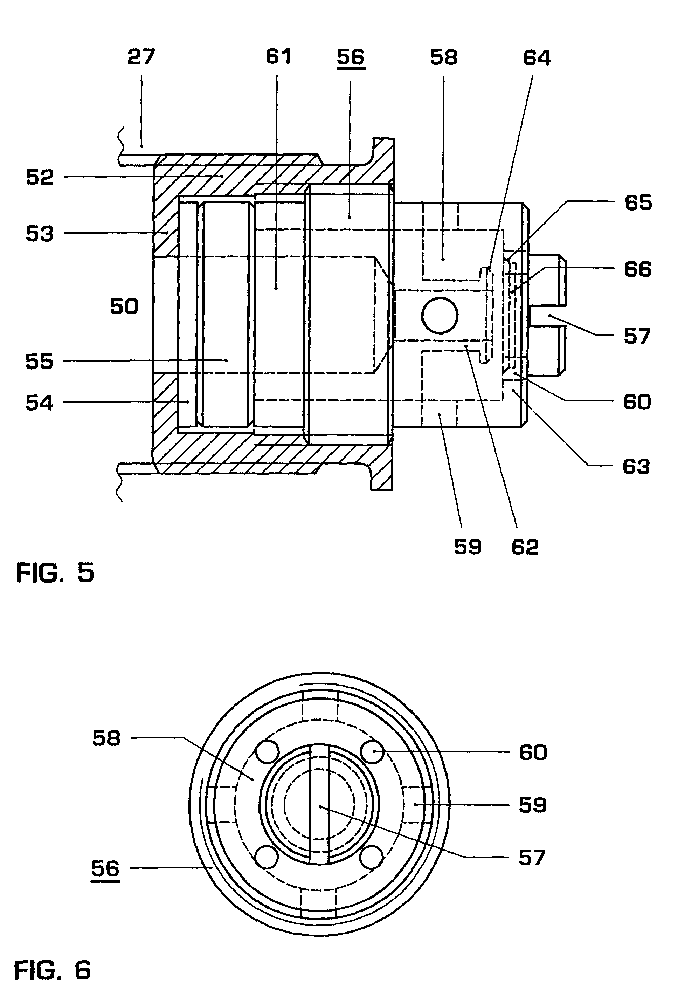

Durch die Wand des Gehäuseelements 27 ist auch eine Belüftungsöffnung 50 geführt, in die eine bolzenförmig ausgebildete Belüftungsvorrichtung 51 eingeschraubt ist. Wie aus Fig.5 ersichtlich ist, weist diese Belüftungsvorrichtung eine mit einem Aussengewinde versehene und durch Einschrauben in der Belüftungsöffnung 50 fixierbare Buchse 52 auf. Die Buchse 52 ist an der nach aussen weisenden Stirnseite offen. Die dem Inneren des von Hohlflansch 26 und Gehäuseelement 27 gebildeten Metallgehäuses zugewandte Stirnseite der Buchse 52 wird von einer an die hohlzylinderförmige Buchsenwand angesetzten Wand 53 mit einer zentral angeordneten Öffnung gebildet. Im Inneren der Buchse 52 sind ein auf der Wand 53 abgestützter Dichtungsring 54, eine auf dem Dichtungsring aufliegende Membran 55 und ein zylinderförmiger Bolzen 56 angeordnet. Der Bolzen 56 weist auf seiner Mantelfläche ein mit einem Innengewinde der Buchse 52 zusammenwirkendes Aussengewinde auf und an seiner ausserhalb der Belüftungsöffnung 50 liegenden Stirnfläche einen radial geführten Schlitz 57 für einen Schraubendreher. Durch Einschrauben des Bolzens 56 wird die Membran 55 gegen den auf der Wand 53 abgestützten Dichtungsring 54 gepresst und wird so eine gasdichte Lagerung der Membran 55 in der Buchse 52 erreicht. Mittels eines in die Gewindegänge eingelagerten wasserdichten Klebemittels wird die Buchse 52 in der Belüftungsöffnung 50 festgesetzt.

Die Membran 55 wirkt wie ein luftlässiges, staubabscheidendes und wasserabweisendes Ventil, welches im Gehäuseinneren vorhandenen oder dort gebildeten Wasserdampf nach aussen, nicht aber Wasser von aussen ins Gehäuseinnere führt. Kondenswasserbildung im Gehäuseinneren und damit eine Beeinträchtigung der Funktionsfähigkeit der Auswertevorrichtung 23 bzw. 23' werden so vermieden. Zugleich verhindert die Membran 55 den Zutritt von Staub ins Gehäuseinnere. Die Membran ist aus einer oder mehreren Lagen eines vorzugsweise als Gewebe ausgebildeten Fasermaterials aufgebaut. Solches Material wird beispielsweise von der Firma GORE unter dem als eingetragene Marke registrierten Handelsnamen GORETEX vertrieben.

Der Membran vorgeschaltet ist ein vom Bolzen 56 gebildeter Spritzwasserschutz. Der Spritzwasserschutz enthält ein den Zutritt von Spritzwasser an die Membran 55 verhinderndes und den Austritt von eingedrungem Spritzwasser ermöglichendes Labyrinth von Kanälen.

In den Figuren 5 bis 7 ist das Labyrinth gestrichelt dargestellt. Es weist eine im Bolzeninneren angeordnete Vorkammer 58 auf. Diese Vorkammer 58 ist ringförmig ausgebildet und kommuniziert über acht Öffnungen 59 und 60 mit dem Aussenraum. Von diesen acht Öffnungen sind vier gegeneinander um 90° versetzt angeordnete Öffnungen 59 radial und vier gegeneinander ebenfalls um 90° versetzt angeordnete Öffnungen 60 axial nach aussen geführt. Das Labyrinth weist ferner eine im Bolzen 56 in axialer Richtung erstreckte und an die Membran 55 geführte Hauptkammer 61 auf. Diese Hauptkammer 61 ist über mindestens eine Schikane mit der Vorkammer 58 verbunden.

Zur Verbindung der Haupt- 61 und der Vorkammer 58 ist ein von einem pilzförmig ausgebildeten, axial ausgerichteten hohlen Zapfen 62 und einer im wesentlichen quer zum Zapfen 62 ausgerichteten Wand 63 begrenzter Kanal vorgesehen. Der der Wand 63 zugewandte Rand 64 des Pilzhutes und ein gegenüberliegender Rand 65 einer in die Wand eingelassenen, kreisförmigen Nut 66 sind unter Bildung eines hohlkegelstumpfförmigen Ringkanals abgeschrägt ausgeführt.

Die in der Wand 63 vorgesehenen vier axial geführten Öffnungen 60 sind derart angeordnet, dass eintretendes Spritzwasser lediglich in die Vorkammer 58 oder allenfalls auf den abgeschrägten Rand 64 des Pilzhutes trifft. Die radial geführten Öffnungen 59 sind derart in der Mantelfläche des Bolzens 56 angeordnet, dass eintretendes Spritzwasser lediglich auf den Pilzfuss triffen kann. Eintretendes Spritzwasser kann daher nicht in die Hauptkammer 61 gelangen und wird in jeder Lage der Belüftungsvorrichtung 51 und damit auch des Metallgehäuses über mindestens eine der Öffnungen 59 und 60 wieder aus der Vorkammer 58 entfernt. Eine Ablagerung von Wasser auf der Membran 55 kann so mit grosser Sicherheit erfolgreich vermieden werden. Durch abgelagertes - gegebenenfalls gefrierendes-Wasser, könnte sonst die Membran 55 verstopft werden. Im Gehäuseinneren gebildeter Wasserdampf könnte dann nicht mehr durch die Ventilwirkung aufweisende Membran 55 in die Hauptkammer 61 und von dort in den Aussenraum geführt werden.

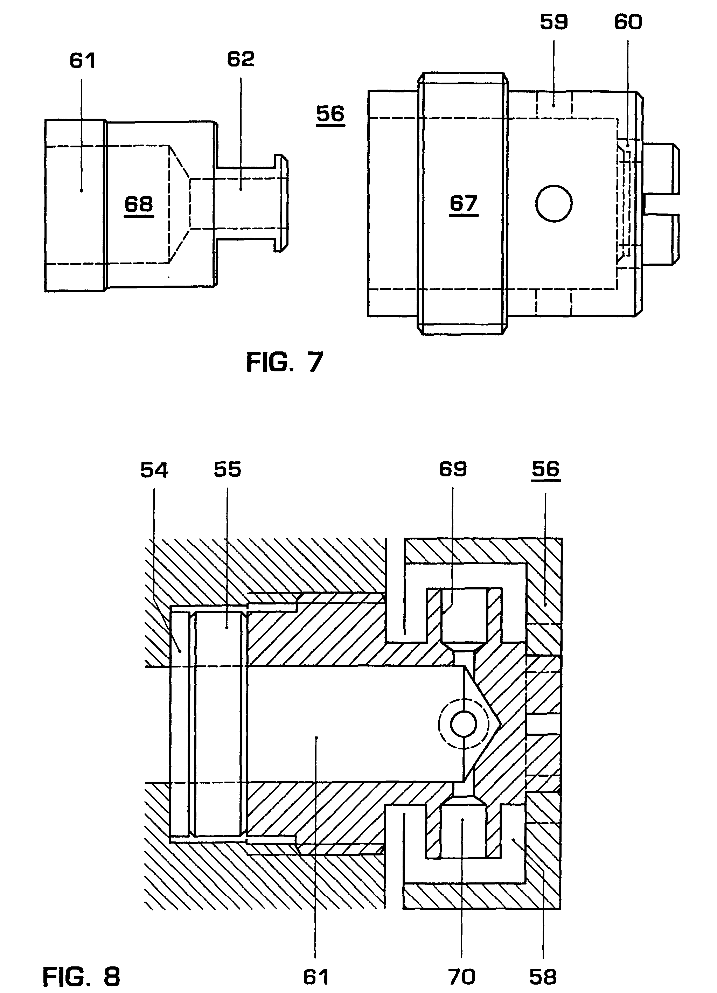

Wie aus Fig.7 ersichtlich ist, besteht der Bolzen 56 aus einem die Öffnungen 59 und 60 enthaltenden topfförmigen Grundkörper 67 und einem den Zapfen 62 und die Hauptkammer 61 enthaltenden, flaschenförmigen Hohlkörper 68. Durch Einpressen des Hohlkörpers 68 in den Grundkörper 67 kann so in besonders einfacher Weise der das Labyrinth enthaltende Bolzen 56 hergestellt werden.

Eine alternative Ausführungsform des Bolzens ist aus Fig.8 ersichtlich. Bei dieser Ausführungsform sind zur Verbindung der Haupt- 61 und der Vorkammer 58 mehrere in Umfangsrichtung verteilt angeordnete, radial geführte und mit jeweils einem überkragenden Rohrabschnitt 69 in die Vorkammer 58 einmündende Kanäle 70 vorgesehen.

### Bezugszeichenliste

- 1, 2: Flansche
- 3: Kapselungsrohr
- 4, 5: Rohrabschnitte
- 6: Schrauben
- 7: Dichtungsring
- 8: Achse
- 9: Stromleiter
- 10: Rogowskispulen
- 11: Messelektrode
- 12: Schrauben
- 13: Eingussarmatur
- 14: Isolator
- 15: Tragring
- 16: Haltering
- 17,18: Schrauben
- 19, 20: Leiterabschnitte
- 21, 22: Abschirmungen
- 23, 23': Auswertevorrichtungen
- 25: Schrauben
- 26: Hohlflansch
- 27: Gehäuseelement
- 28, 28': Steckvorrichtungen
- 29: Federleiste
- 30: Schrauben
- 31, 32: Kupplungsstücke
- 33: Steckkontakte
- 34, 35: Kontakfflächen
- 36: O-Ring
- 37, 38: Nuten
- 39: Printplatte
- 40: Kontaktfedern
- 41: Abschirmung
- 42: Kühlrippen
- 43: Kontaktfedern
- 44: Abschirmung
- 45: Stecker
- 46: Kragen
- 47: Auskragung
- 48: Materialaussparung
- 49: Stecker
- 50: Belüftungsöffnung
- 51: Belüftungsvorrichtung
- 52: Buchse
- 53: Wand
- 54: Dichtungsring
- 55: Membran
- 56: Bolzen
- 57: Schlitz
- 58: Vorkammer
- 59, 60: Öffnungen
- 61: Hauptkammer
- 62: Zapfen
- 63: Wand
- 64, 65: Ränder
- 66: Nut
- 67: Grundkörper
- 68: Hohlkörper
- 69: Rohrabschnitt
- 70: Kanäle

## Patentansprüche

1. Elektronisches Gerät mit einem zweiteiligen Gehäuse (26, 27), mindestens einer staubdicht vom Gehäuse umschlossenen und mit mindestens einer elektronischen Komponente bestückten Printplatte (39), mindestens einer durch eines beider Gehäuseteile geführte Belüftungsöffnung (50) und mit einer in der Belüftungsöffnung angeordneten Belüftungsvorrichtung (51) mit einer luftdurchlässigen und wasserabweisenden Membran (55), dadurch gekennzeichnet, dass in die Belüftungsöffnung (50) in wasserdichter Weise eine mit einem Innengewinde versehene Buchse (52) eingesetzt ist, welche an der nach aussen weisenden Stirnseite offen ist und an der dem Gehäuseinneren zugewandten Stirnseite eine in Richtung der Buchsenachse geführte Wand (53) und mindestens eine von der Wand begrenzte Öffnung aufweist, und dass im Inneren der Buchse (52) ein auf der Wand abgestützter Dichtungsring (54), die auf dem Dichtungsring (54) aufliegende Membran (55) und ein mit dem Innengewinde zusammenwirkendes und die Membran (55) gegen den Dichtungsring (54) pressendes Teil eines als Spritzwasserschutz ausgebildeten Bolzens (56) angeordnet sind.

2. Gerät nach Anspruch 1, dadurch gekennzeichnet, dass die Buchse (52) ein Aussengewinde aufweist, welches mit einem Innengewinde des die Belüftungsöffnung (50) aufnehmenden Gehäuseteils (27) zusammenwirkt, und mittels eines in die Gewindegänge eingelagerten wasserdichten Klebemittels in der Belüftungsöffnung (50) festgesetzt ist.

3. Gerät nach einm der Ansprüche 1 oder 2, dadurch gekennzeichnet, dass der Bolzen (56) ein den Zutritt von Spitzwasser an die Membran (55) verhinderndes, den Austritt von eingedrungem Spritzwasser ermöglichendes Labyrinth von Kanälen enthält.

4. Gerät nach Anspruch 3, dadurch gekennzeichnet, dass der Bolzen (56) eine ringförmig ausgebildete und über mehrere Wandöffnungen (59, 60) nach aussen geführte Vorkammer (58) enthält sowie eine in axialer Richtung erstreckte und an die Membran (55) geführte Hauptkammer (61), welche über mindestens eine Schikane mit der Vorkammer (58) verbunden ist.

5. Gerät nach Anspruch 4, dadurch gekennzeichnet, dass zur Verbindung der Haupt- (61) und der Vorkammer (58) mehrere in Umfangsrichtung verteilt angeordnete, radial geführte und mit jeweils einem überkragenden Rohrabschnitt (69) in die Vorkammer (58) einmündende Kanäle (70) vorgesehen sind.

6. Gerät nach Anspruch 4, dadurch gekennzeichnet, dass zur Verbindung der Haupt- (61) und der Vorkammer (58) ein von einem pilzförmig ausgebildeten, axial ausgerichteten hohlen Zapfen (62) und einer im wesentlichen quer zum Zapfen (62) ausgerichteten Wand (63) begrenzter Kanal vorgesehen ist.

7. Gerät nach Anspruch 6, dadurch gekennzeichnet, dass der der Wand (63) zugewandte Rand (64) des Pilzhutes und ein gegenüberliegender Rand (65) einer in die Wand (63) eingelassenen, kreisförmigen Nut (66) unter Bildung eines hohlkegelstumpfförmigen Ringkanals abgeschrägt ausgeführt sind.

8. Gerät nach Anspruch 7, dadurch gekennzeichnet, dass ein erster Teil der die Vorkammer (58) nach aussen führenden Öffnungen (60) derart in der Wand (63) angeordnet ist, dass eintretendes Spritzwasser lediglich in die Vorkammer (58) oder allenfalls auf den abgeschrägten Rand (64) des Pilzhutes gelangt.

9. Gerät nach Anspruch 8, dadurch gekennzeichnet, dass ein zweiter Teil der die Vorkammer (58) nach aussen führenden Öffnungen (59) derart in der Mantelfläche des Bolzens (56) angeordnet ist, dass eintretendes Spritzwasser lediglich an den Pilzfuss gelangt.

10. Gerät nach einem der Ansprüche 6 bis 9, dadurch gekennzeichnet, dass der Zapfen (62) in einen die Wand (63) enthaltenden topfförmigen Grundkörper (67) des Bolzens (56) eingepresst ist.

## Claims

1. Electronic instrument with a two-part housing (26, 27), with at least one printed board (39) surrounded in a dusttight manner by the housing and fitted with at least one electronic component, with at least one ventilating orifice (50) led through one of the two housing parts, and with a ventilating device (51) arranged in the ventilating orifice and having an air-permeable and water-repellant diaphragm (55), characterized in that a bush (52) provided with an internal thread is inserted in a watertight manner into the ventilating orifice (50), said bush being open on the outwards-facing end face and having, on the end face facing the housing interior, a wall (53) guided in the direction of the bush axis and at least one orifice delimited by the wall, and in that a sealing ring (54) supported on the wall, the diaphragm (55) resting on the sealing ring (54) and a part of a bolt (56) designed as a splashwater guard, said part cooperating with the internal thread and pressing the diaphragm (55) against the sealing ring (54), are arranged inside the bush (52).

2. Instrument according to Claim 1, characterized in that the bush (52) has an external thread, which cooperates with an internal thread of the housing part (27) receiving the ventilating orifice (50), and is fixed in the ventilating orifice (50) by means of a watertight adhesive embedded in the thread flights.

3. Instrument according to one of Claims 1 or 2, characterized in that the bolt (56) contains a labyrinth of ducts which prevents splashwater from infiltrating the diaphragm (55) and which allows splashwater which has penetrated to escape.

4. Instrument according to Claim 3, characterized in that the bolt (56) contains an annularly designed prechamber (58) led outwards via a plurality of wall orifices (59, 60) and a main chamber (61) which is extended in the axial direction and is led to the diaphragm (55) and which is connected to the prechamber (58) via at least one baffle.

5. Instrument according to Claim 4, characterized in that a plurality of radially guided ducts (70) arranged in a circumferentially distributed manner and opening into the prechamber (58) in each case by means of a projecting tubular portion (69) are provided for connecting the main chamber (61) and the prechamber (58).

6. Instrument according to Claim 4, characterized in that a duct delimited by a mushroom-shaped, axially oriented hollow pin (62) and by a wall (63) oriented essentially transversely to the pin (62) is provided for connecting the main chamber (61) and the prechamber (58).

7. Instrument according to Claim 6, characterized in that that edge (64) of the mushroom cap which faces the wall (63) and an opposite edge (65) of a circular groove (66) let into the wall (63) have a bevelled design so as to form an annular duct in the shape of a hollow cone frustum.

8. Instrument according to Claim 7, characterized in that a first part of the orifices (60) leading the prechamber (58) outwards is arranged in the wall (63) in such a way that splashwater entering passes merely into the prechamber (58) or, at most, onto the bevelled edge (64) of the mushroom cap.

9. Instrument according to Claim 8, characterized in that a second part of the orifices (59) leading the prechamber (58) outwards is arranged in the outer surface of the bolt (56) in such a way that splashwater entering reaches merely the mushroom stem.

10. Instrument according to one of Claims 6 to 9, characterized in that the pin (62) is pressed into a pot-shaped basic body (67) of the bolt (56), said basic body containing the wall (63).

## Revendications

1. Appareil électronique avec un boîtier (26, 27) en deux parties, au moins une carte à circuits imprimés (39) scellée de manière étanche à la poussière du boîtier et équipée d'au moins un composant électronique, au moins une ouverture d'aération (50) dirigée à travers une des deux parties de boîtier et avec un dispositif d'aération (51) disposé dans l'ouverture d'aération avec une membrane (55) perméable à l'air et refoulant l'eau, caractérisé en ce que, dans l'ouverture d'aération, (50) une boîte (52) pourvue d'un filetage femelle est disposée de manière étanche à l'eau, boîte qui est ouverte sur sa face d'about tournée vers l'extérieur et qui présente, sur sa face d'about tournée vers l'intérieur du boîtier, une paroi (53) dirigée en direction de l'axe de boîte et au moins une ouverture délimitée par la paroi, et en ce que sont disposés, à l'intérieur de la boîte (52), un anneau d'étanchéité (54) appuyé sur la paroi, la membrane (55) placée sur l'anneau d'étanchéité (54) et une partie d'un goujon (56) formé à titre de protection contre les projections d'eau, partie agissant conjointement avec le filetage femelle et pressant la membrane (55) contre l'anneau d'étanchéité (54).

2. Appareil suivant la revendication 1, caractérisé en ce que la boîte (52) présente un filetage mâle qui agit conjointement avec un filetage femelle de la partie de boîtier (27) reprenant l'ouverture d'aération (50), et qui est fixé dans l'ouverture d'aération (50) à l'aide d'un adhésif étanche à l'eau, disposé dans les pas de vis.

3. Appareil selon l'une quelconque des revendications 1 ou 2, caractérisé en ce que le goujon (56) contient un labyrinthe de canaux, empêchant l'entrée de projections d'eau vers la membrane (55) et permettant la sortie des projections d'eau qui ont pénétré.

4. Appareil suivant la revendication 3, caractérisé en ce que le goujon (56) comprend une préchambre (58) formée en forme d'anneau et menant vers l'extérieur à travers plusieurs ouvertures de parois (59, 60) ainsi qu'une chambre principale (61) s'étendant en direction axiale, et menant à la membrane (55), et qui est reliée par au moins une chicane à la préchambre (58).

5. Appareil suivant la revendication 4, caractérisé en ce que, pour relier la chambre principale (61) et la préchambre (58), on prévoit plusieurs canaux (70) disposés de manière répartie en direction périphérique, dirigés de manière radiale et présentant chaque fois une section de tuyau (69) saillante débouchant dans la préchambre (58).

6. Appareil suivant la revendication 4, caractérisé en ce que, pour relier la préchambre (58) et la chambre principale (61), on a prévu un canal limité par un tourillon (62) creux, en forme de champignon, disposé axialement et une paroi (63) disposée essentiellement transversalement par rapport au tourillon (62).

7. Appareil suivant la revendication 6, caractérisé en ce que le bord (64) du chapeau du champignon, tourné vers la paroi (63) et un bord opposé (65) d'une rainure (66) circulaire intégrée dans la paroi (63) sont réalisés en biseau par formation d'un canal annulaire en forme tronquée de cône creux.

8. Appareil suivant la revendication 7, caractérisé en ce qu'une première partie des ouvertures (60) menant vers l'extérieur de la préchambre (58) est agencée dans la paroi (63) de telle sorte que la projection d'eau entrante atteigne uniquement la préchambre (58) ou, à la rigueur, le bord chanfreiné (64) du chapeau du champignon.

9. Appareil suivant la revendication 8, caractérisé en ce qu'une deuxième partie des ouvertures (59) menant vers l'extérieur de la préchambre (58) sont agencées dans la surface latérale du goujon (56) de sorte que la projection d'eau pénétrant n'atteint que le pied du champignon.

10. Appareil selon les revendications 6 à 9, caractérisé en ce que le tourillon (62) est enfoncé dans un corps de base (67) du goujon (56), en forme de pot et contenant la paroi (63).
